# EUROPEAN PATENT APPLICATION

(11) **EP 3 236 505 A1**
(43) Date of publication of application: **25.10.2017**
(21) Application number: 15869837.3
(22) Date of filing: 08.12.2015
(51) Int. Cl.: H01L 33/14, H01L 33/32

(54) **LIGHT EMITTING ELEMENT**

(30) Priority: 19.12.2014 JP 2014257859
(71) Applicant: STANLEY ELECTRIC CO., LTD., Tokyo 153-8636 (JP)
(72) Inventor: OBATA, Toshiyuki, Shunan-shi Yamaguchi 745-8648 (JP)
(74) Representative: Klang, Alexander H.
(86) International application number: PCT/JP2015/084356
(87) International publication number: WO 2016/098632

(57) **Abstract**

Provided is a light-emitting element which is capable of improving the external quantum efficiency by controlling a dopant concentration of an interface between a light-emitting layer and another semiconductor layer.

A nitride-based semiconductor light-emitting element includes: a first semiconductor layer 20 of a first conductivity type; a second semiconductor layer 50 of a second conductivity type; a carrier block layer 40 provided in the second semiconductor layer 50 on a side closer to the first semiconductor layer 20 and containing an impurity of the second conductivity type; a light-emitting layer 30 provided between the first semiconductor layer 20 and the carrier block layer 40; and a spacer layer 35 which is provided between the carrier block layer 40 and the light-emitting layer 30 and makes the concentration of the impurity of the second conductivity type in the vicinity of the interface with the light-emitting layer 30 be at a predetermined concentration or less.

## Description

### TECHNICAL FIELD

The present invention relates to light emitting elements. More particularly, the present invention relates to a nitride-based compound semiconductor light emitting element.

### BACKGROUND ART

Conventionally known is a nitride semiconductor element having an active layer between an n-type layer and a p-type layer. The active layer has a quantum well structure which includes a well layer made of a nitride semiconductor containing Al and which includes a p-side barrier layer provided closest to the p-type layer and made of a nitride semiconductor containing Al, the nitride semiconductor having greater band gap energy than that of the well layer, and which includes an n-side barrier layer provided closest to the n-type layer. The active layer is sandwiched between light guide layers provided in close proximity to the active layer so as to form a waveguide. The light guide layer provided in the p-type layer is made of a nitride semiconductor layer having less band gap energy than that of the barrier layer. Between the active layer and the light guide layer provided in the p-type layer, there is provided a carrier confinement layer which is made of a nitride semiconductor containing Al having band gap energy greater than that of the active layer and which is doped with a p-type impurity (for example, see Patent Literature 1). According to the nitride semiconductor element disclosed in Patent Literature 1, it is possible to provide an active layer and a waveguide structure, which enable lasing in a short-wavelength region of 380 nm or less.

On the other hand, also reported were the properties of a light-emitting diode in which a barrier layer of an InGaN/GaN multiple quantum well is doped with Mg (for example, see Non-Patent Literature 1). According to a technique disclosed in Non-Patent Literature 1, a light-emitting diode doped with Mg can better improve the optical output than a light-emitting diode with a barrier layer not doped with Mg.

### CITATION LIST

### PATENT LITERATURE

Patent Literature 1: Japanese Patent No. 4161603

Non-Patent Literature 1: Sang-Heon Han, Chu-Young Cho, Sang-Jun Lee, Tae-Young Park, Tae-Hun Kim, Seung Hyun Park, Sang Won Kang, Je Won Kim, Yong Chun Kim, and Seong-Ju Park, "Effect of Mg doping in the barrier or InGaN/GaN multiple quantum well on optical power of light emitting diodes", APPLIED PHYSICS LETTERS 96, 051113 (2010)

### SUMMARY OF INVENTION

### TECHNICAL PROBLEM

However, according to a technique disclosed in Patent Literature 1, it is stated that a well layer in the quantum well is doped with a dopant having a predetermined concentration, thereby improving the efficiency of light emission (for example, see paragraph [0071] of Patent Literature 1). However, attention is not focused on the doping concentration in the interface between the light-emitting layer and another semiconductor layer. Furthermore, according to a technique disclosed in Non-Patent Literature 1, attention is focused on the doping of a barrier layer with Mg, but this technique also focuses no attention on the doping concentration in the interface between the light-emitting layer and another semiconductor layer.

Thus, an object of the present invention is to provide a light-emitting element which is capable of improving the external quantum efficiency by controling the dopant concentration in the interface between the light-emitting layer and another semiconductor layer.

### SOLUTION TO PROBLEM

In order to achieve the aforementioned object, the present invention provides a nitride-based semiconductor light-emitting element including: a first semiconductor layer of a first conductivity type; a second semiconductor layer of a second conductivity type different from the first conductivity type; a carrier block layer provided in the second semiconductor layer on a side closer to the first semiconductor layer and containing an impurity of the second conductivity type; a light-emitting layer provided between the first semiconductor layer and the carrier block layer; and a spacer layer which is provided between the carrier block layer and the light-emitting layer and makes the concentration of the impurity of the second conductivity type in the vicinity of the interface with the light-emitting layer be at a predetermined concentration or less.

Furthermore, in the aforementioned nitride-based semiconductor light-emitting element, the spacer layer may control the concentration of the impurity of the second conductivity type in the vicinity of the interface at 1 × 10¹⁷ cm⁻³ or less.

Furthermore, in the aforementioned nitride-based semiconductor light-emitting element, the light-emitting layer may be a quantum well layer with a barrier layer and a well layer deposited alternately, and the spacer layer may be in contact with the well layer, and the concentration of the impurity of the second conductivity type in the interface between the spacer layer and the well layer may be 1 × 10¹⁷ cm⁻³ or less.

Furthermore, in the aforementioned nitride-based semiconductor light-emitting element, the first semiconductor layer is provided on top of a semiconductor substrate, and the first semiconductor layer, the second semiconductor layer, the light-emitting layer, the spacer layer, and the carrier block layer may be configured to contain an AlGaN-based semiconductor.

Furthermore, in the aforementioned nitride-based semiconductor light-emitting element, the semiconductor substrate may be an AlN substrate, and the first semiconductor layer may be provided on the C-plane of the AlN substrate.

Furthermore, in the aforementioned nitride-based semiconductor light-emitting element, the impurity of the second conductivity type may be Mg, Zn, Ca, C, or Be.

### ADVANTAGEOUS EFFECTS OF THE INVENTION

According to a light-emitting element of the present invention, it is possible to provide a light-emitting element which is capable of improving the external quantum efficiency by controling the dopant concentration in the interface between the light-emitting layer and another semiconductor layer.

### BRIEF DESCRIPTION OF DRAWINGS

Fig. 1 is a schematic view illustrating a cross section of a light-emitting element according to an embodiment.
Fig. 2 is a cross-sectional view illustrating the vicinity of the light-emitting layer according to the embodiment.
Fig. 3 is a schematic view illustrating part of an energy band diagram of a semiconductor layer constituting the light-emitting element according to the embodiment.
Fig. 4 is a view illustrating a relation between the sub-peak emission intensity and the Mg concentration of light-emitting elements according to Embodiments and light-emitting elements according to Comparative Examples.

### DESCRIPTION OF EMBODIMENTS

### [Embodiments]

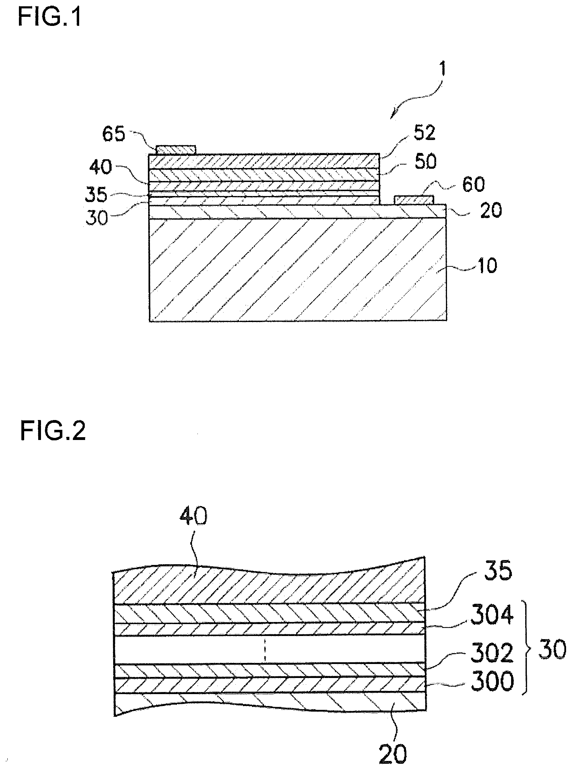

Fig. 1 schematically illustrates, in cross section, an example of a light-emitting element according to an embodiment of the present invention. Furthermore, Fig. 2 schematically illustrates, in cross section, an example of the vicinity of the light-emitting layer according to the embodiment of the present invention. Note that since the drawings to be referred to in the embodiment are only schematically illustrated, for example, the thicknesses and sizes of respective semiconductor layers shown in each drawing do not always reflect actual ones.

### (Outline of Structure of Light-Emitting Element 1)

A light-emitting element 1 according to the embodiment is configured, for example, mainly from GaN-based or AlGaN-based III-V group compound semiconductors, and is a light-emitting diode (LED) or a laser diode as a light-emitting element for radiating light in a deep ultraviolet region. As an example, the light-emitting element 1 is rectangular when viewed in a plan view. The light-emitting element 1 includes: a substrate 10; a first semiconductor layer 20 of a first conductivity type provided on top of the substrate 10; a light-emitting layer 30 provided on top of the first semiconductor layer 20; a spacer layer 35 provided on top of the light-emitting layer 30; a carrier block layer 40 provided on top of the spacer layer 35; a second semiconductor layer 50, which is provided on top of the carrier block layer 40, of a second conductivity type different from the first conductivity type; and a third semiconductor layer 52 provided on top of the second semiconductor layer 50.

Note that it is to be understood that the description of "one semiconductor layer is provided on top of another semiconductor layer" in this embodiment includes a case in which one semiconductor layer is provided immediately on top of another semiconductor layer and a case in which between one semiconductor layer and another semiconductor layer is provided still another semiconductor layer (i.e., one semiconductor layer is provided above another semiconductor layer).

Furthermore, the light-emitting element 1 includes: a first electrode 60 provided on one region of the first semiconductor layer 20 opposite to the substrate 10; and a second electrode 65 provided on one region of a surface of the third semiconductor layer 52 opposite to the second semiconductor layer 50.

Here, the first semiconductor layer 20 contains a dopant as an impurity of the first conductivity type, and the second semiconductor layer 50 and the third semiconductor layer 52 each contain a dopant of the second conductivity type that is different from the first conductivity type. Then, in this embodiment, the carrier block layer 40 is configured to contain a dopant of the second conductivity type. Furthermore, by way of example, the light-emitting layer 30 is configured to have a quantum well layer that includes a well layer and a barrier layer, which are alternately deposited.

The spacer layer 35 is provided between the light-emitting layer 30 and the carrier block layer 40, and adjusts the concentration of the impurity of the second conductivity type in the vicinity of the interface between the light-emitting layer 30 and the spacer layer 35 to a predetermined concentration or less. For example, the spacer layer 35 is provided in contact with a well layer of the light-emitting layer 30 on a side closer to the carrier block layer 40 and has such a function and configuration that substantially prevent an impurity from the carrier block layer 40 from reaching the interface between the well layer closest to the carrier block layer 40 and the spacer layer 35 or the vicinity thereof.

The inventor has studied the behavior of dopants in each semiconductor layer that constitutes the light-emitting element, the influence of a dopant on each semiconductor layer, and the influence of the concentration of a dopant on the external quantum efficiency. In the course of the studies, the inventor has found for the first time the phenomenon that the external quantum efficiency of the light-emitting element 1 is improved by substantially preventing a dopant diffused from the carrier block layer 40 from being present not only in the light-emitting layer but also in the vicinity of the interface between a well layer that constitutes the light-emitting layer 30, the well layer being closest to the carrier block layer 40, and the spacer layer 35 (or an undoped semiconductor layer provided closest to the carrier block layer 40). This has led to the development of the present invention. Now, a description will be given along the embodiments in more detail.

### (Details of Structure of Light-Emitting Element 1)

By way of example, a description will be given of an example with the first conductivity type being n-type and the second conductivity type being p-type.

### (Substrate 10)

The substrate 10 is a semiconductor substrate having a predetermined thickness and a plane orientation or a monocrystalline substrate such as of sapphire. For example, in the case where a semiconductor substrate is used as the substrate 10, it is possible to employ a silicon carbide (SiC) substrate, a gallium nitride (GaN) substrate, or an aluminum nitride (AlN) substrate having a high thermal conductivity. In the embodiment, in order to prevent the occurrence of crystalline defects such as dislocations by using a lattice matching substrate and thereby deposit high-quality semiconductor layers, by way of example, a C-plane AlN substrate is used as the substrate 10. Note that to use, for the substrate 10, a material such as sapphire having lattice constants significantly different from the lattice constants of the first semiconductor layer 20, it is possible to provide a buffer layer between the substrate 10 and the first semiconductor layer 20.

### (Each Semiconductor Layer)

The first semiconductor layer 20, the light-emitting layer 30, the spacer layer 35, the carrier block layer 40, the second semiconductor layer 50, and the third semiconductor layer 52 are deposited in that order, each being configured mainly from a nitride-based compound semiconductor. These semiconductor layers are configured, for example, from a compound semiconductor expressed by AlₓGa₁₋ₓN (where 0 ≤ × ≤ 1). Here, the carrier block layer 40 is a semiconductor layer for reducing carriers (for example, electrons) propagating from the first semiconductor layer 20 toward the second semiconductor layer 50.

Specifically, the first semiconductor layer 20 is made of an AlGaN-based compound semiconductor containing an n-type dopant. On the other hand, the carrier block layer 40, the second semiconductor layer 50, and the third semiconductor layer 52 are made of an AlGaN-based compound semiconductor containing a p-type dopant.

More specifically, the first semiconductor layer 20 is made of an AlₓGa₁₋ₓN (where 0 ≤ x ≤ 1) containing an n-type dopant such as Si or Se at a predetermined concentration. By way of example, the first semiconductor layer 20 is made of an Al_{0.75}Ga_{0.25}N layer containing an n-type dopant. The concentration of the n-type dopant contained in the first semiconductor layer 20 is 1 × 10¹⁷ cm⁻³ or more and 5 × 10²⁰ cm⁻³ or less.

The carrier block layer 40 is made of AlₓGa₁₋ₓN (where 0 ≤ x ≤ 1) containing a p-type dopant such as Mg, Zn, Ca, C, or Be at a predetermined concentration. In this embodiment, since the carrier block layer 40 functions to reduce carriers propagating from the first semiconductor layer 20 toward the second semiconductor layer 50, the carrier block layer 40 is preferably made of a material having a greater band gap than those of the other semiconductor layers. By way of example, the carrier block layer 40 is made of AlN containing a p-type dopant. The concentration of the p-type dopant contained in the carrier block layer 40 is 1 × 10¹⁸ cm⁻³ or more and 5 × 10²⁰ cm⁻³ or less.

On the other hand, the second semiconductor layer 50 and the third semiconductor layer 52 are made of AlₓGa₁₋ₓN (where 0 ≤ x ≤ 1) containing a p-type dopant at a predetermined concentration. Here, the second semiconductor layer 50 has a function as a clad layer, and the third semiconductor layer 52 has a function as a contact layer. By way of example, the second semiconductor layer 50 is made of Al_{0.8}Ga_{0.2}N containing a p-type dopant, and the third semiconductor layer 52 is made of GaN containing a p-type dopant. The concentration of the p-type dopant contained in the second semiconductor layer 50 is 1 × 10¹⁷ cm⁻³ or more and 5 × 10²⁰ cm⁻³ or less, and the concentration of the p-type dopant contained in the third semiconductor 52 is 1 × 10¹⁷ cm⁻³ or more and 5 × 10²⁰ cm⁻³ or less.

The light-emitting layer 30 emits light at wavelengths in a predetermined range when a current is supplied from outside. Specifically, the light-emitting layer 30 is configured to emit light at wavelengths including a deep ultraviolet region (for example, light at an emission peak wavelength of 200 nm or greater and 350 nm or smaller). Here, the light-emitting layer 30 is formed to have a quantum well structure, in which a barrier layer (for example, a barrier layer 300) and a well layer (for example, a well layer 302 or a well layer 304) are alternately layered between the first semiconductor layer 20 and the carrier block layer 40, specifically, between the first semiconductor layer 20 and the spacer layer 35. By way of example, the light-emitting layer 30 includes a pair of an Al_{0.65}Ga_{0.35}N layer acting as a barrier layer containing an n-type dopant and an Al_{0.50}Ga_{0.50}N layer acting as an undoped well layer. Then, by way of example, between the carrier block layer 40 and the light-emitting layer 30 is formed the spacer layer 35 made of undoped Al_{0.65}Ga_{0.35}N.

Note that the light-emitting layer 30 may also have a multiple quantum well structure including a plurality of pairs of a barrier layer and a well layer (i.e., a structure in which a plurality of barrier layers and well layers are alternately deposited). Furthermore, the concentration of the n-type dopant contained in the barrier layer is 1 × 10¹⁷ cm⁻³ or more and 5 × 10²⁰ cm⁻³ or less. Here, the barrier layer may or may not contain an n-type dopant. Furthermore, in the embodiment, the "undoped" semiconductor layer is a semiconductor layer which is formed in a manufacturing process without any dopant intentionally added thereto, and thus never excludes those that contain an unavoidable impurity.

Here, in the embodiments, the p-type dopant diffused from the carrier block layer 40 is substantially not contained in the interface between the well layer 304 closest to the carrier block layer 40 and the spacer layer 35 in the quantum well structure, and the well layer 304. That is, the spacer layer 35 functions to retain, within the spacer layer 35, most of the dopants diffusing through the carrier block layer 40 toward the well layer 304. Some of the p-type dopants doped in the carrier block layer 40 are diffused through the spacer layer 35 toward the well layer 304. The spacer layer 35 according to the embodiment is capable of retaining dopants diffused toward the well layer 304 therein by forming the spacer layer 35 and each semiconductor layer adjacent to the spacer layer 35 under predetermined growth conditions.

Specifically, the spacer layer 35 serving as an undoped layer is formed so that the concentration profile of a p-type dopant is adjusted in the carrier block layer 40, the spacer layer 35, and the well layer 304 (and the interface between the well layer 304 and the spacer layer 35), and the p-type dopant will substantially not reach the interface between the well layer 304 and the spacer layer 35. More specifically, the concentration of the impurity of the second conductivity type in the vicinity of the interface between the spacer layer 35 and the light-emitting layer 30 (i.e., the interface between the spacer layer 35 and the well layer 304) is preferably controlled at 1 × 10¹⁷ cm⁻³ or less. Note that the spacer layer 35 is preferably formed to have about the same thickness as that of the carrier block layer 40 or to have a greater thickness than that of the carrier block layer 40, and formed to be thicker than a well layer and a barrier layer that are included in the light-emitting layer 30.

### (First Electrode 60 And Second Electrode 65)

The first electrode 60 is made of a material that forms an ohmic contact with the first semiconductor layer 20. Likewise, the second electrode 65 is made of a material that forms an ohmic contact with the third semiconductor layer 52. Furthermore, the first electrode 60 and the second electrode 65 are each configured to include an electrode layer made of a single material or a combination of a plurality of electrode layers partially made of different materials.

For example, for the first semiconductor layer 20 being an n-type semiconductor, the first electrode 60 is constituted by forming a Ti layer, an Al layer, and an Au layer, which have a predetermined thickness, in that order from the first semiconductor layer 20 side. Furthermore, for the third semiconductor layer 52 being a p-type semiconductor, the second electrode 65 is constituted by forming a Ni layer and a Au layer, which have a predetermined thickness, in that order from the third semiconductor layer 52 side. Note that the materials that form the first electrode 60 and the second electrode 65 are not limited to those mentioned above, but may also be made of other metal materials, conductive oxide materials, and/or conductive polymeric materials so long as those materials form an ohmic contact with the first semiconductor layer 20 and the third semiconductor layer 52.

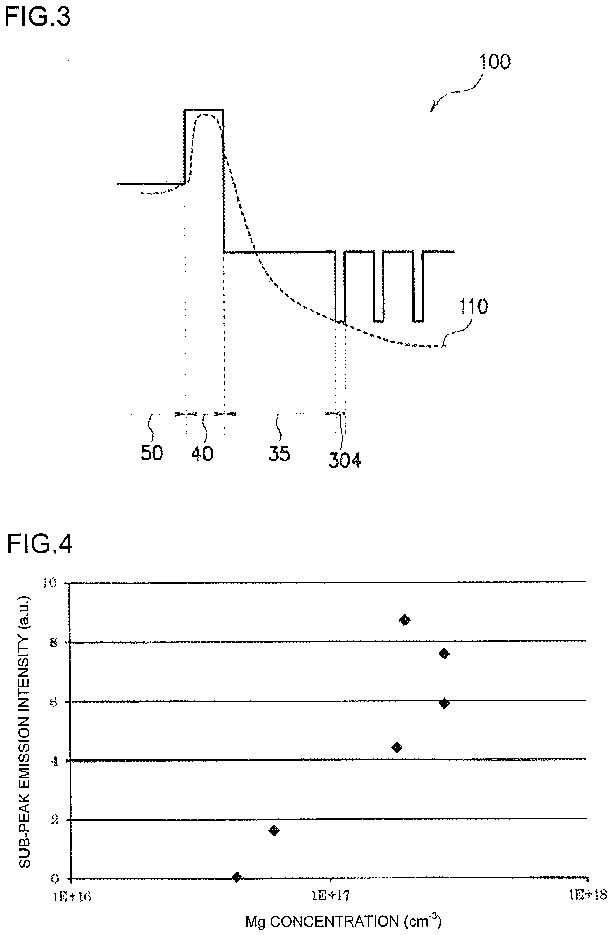

Fig. 3 is a schematic view illustrating part of an energy band diagram of the semiconductor layer that constitutes the light-emitting element according to the embodiment.

Fig. 3 schematically illustrates a concentration profile 110 of a dopant in conjunction with a conceptual band diagram 100 of part of the semiconductor layer that forms the light-emitting element 1. Fig. 3 illustrates part of the second semiconductor layer 50, the carrier block layer 40, the spacer layer 35, and the well layer 304, each of the semiconductor layers being provided from the left side in that order. In this embodiment, in the carrier block layer 40, there exists such a region which has the maximum p-type dopant concentration at least in the two layers, i.e., the carrier block layer 40 and the spacer layer 35. Then, in the thickness direction of the spacer layer 35, the concentration is gradually decreased from the carrier block layer 40 toward the well layer 304 that is closest to the carrier block layer 40.

Then, in this embodiment, in order to reduce a sub-peak light emission from the light-emitting element 1 to improve the external quantum efficiency, it is preferable that a p-type dopant should substantially not be allowed to exist in the interface between the spacer layer 35 and the well layer 304 or in the vicinity of the interface, or the concentration of the p-type dopant in the interface should be significantly reduced (for example, the impurity concentration is 1 × 10¹⁷ cm⁻³ or less). Such a concentration profile 110 can be achieved by growing a semiconductor layer having a predetermined thickness while doping each semiconductor layer with a predetermined dopant at a predetermined doping speed under a predetermined growth temperature that is reached in a predetermined growth temperature up and down profile in a process for forming each semiconductor layer after the carrier block layer formation. More specifically, this includes reducing the growth time of the second conductivity type layer including the carrier block layer (preferably to within 90 minutes), lowering the growth temperature of the second conductivity type layer (preferably to 1030°C or lower), or reducing the concentration of the second conductivity type impurity, making the carrier block layer undoped, or retarding the start of doping of the second conductivity type impurity.

### (Method For Manufacturing Light-Emitting Element 1)

A description will now be given of an example method for manufacturing the light-emitting element 1 according to the embodiment.

First, on top of the substrate 10, for example, an AlGaN-based semiconductor layered structure including a plurality of compound semiconductor layers is formed by the Metal Organic Chemical Vapor Deposition (MOCVD) method. Specifically, on top of the substrate 10, by MOCVD, at a predetermined growth temperature in a predetermined growth time, the layers are formed in the following order: the first semiconductor layer 20 having AlₓGa₁₋ₓN (where 0 ≤ x ≤ 1, the same shall apply hereinafter.) which is doped with an n-type dopant; the light-emitting layer 30 having a predetermined number of pairs of a barrier layer having AlₓGa₁₋ₓN doped with an n-type dopant and a well layer having undoped AlₓGa₁₋ₓN; the spacer layer 35 having undoped AlₓGa₁₋ₓN; the carrier block layer 40 having AlₓGa₁₋ₓN doped with a p-type dopant; the second semiconductor layer 50 having AlₓGa₁₋ₓN doped with a p-type dopant; and the third semiconductor layer 52 having AlₓGa₁₋ₓN doped with a p-type dopant. In this manner, an epitaxial wafer with a semiconductor layered structure formed on top of the substrate 10 is formed.

Note that the source materials to be employed in the MOCVD method may include organometallic compounds such as trimethyl gallium (TMGa), triethyl gallium (TEGa), trimethylaluminum (TMAl), or triethyl aluminum (TEAl), and ammonia (NH₃). Furthermore, as a material for the n-type dopant, it is possible to employ, for example, triethyl silane (TESi). Then, as a material for the p-type dopant, it is possible to employ, for example, biscyclopentadienyl magnesium (Cp₂Mg).

Furthermore, as a material for the n-type dopant, it is possible to use hydrogen selenide (H₂Se), disilane (Si₂H₆), monosilane (SiH₄), diethyl tellurium (DETe), or dimethyl tellurium (DMTe). Then, when Zn is used as the p-type dopant, it is also possible to use, as the material thereof, dimethyl zinc (DMZn) or diethyl zinc (DEZn). As the carrier gas, it is possible to use, for example, hydrogen or nitrogen.

Furthermore, the semiconductor layered structure on top of the substrate 10 can also be formed by other semiconductor layer forming methods such as the Molecular Beam Epitaxy (MBE) method.

Next, after the epitaxial wafer is taken out of the MOCVD equipment, a heat treatment is performed on the semiconductor layered structure formed on the substrate 10 for a predetermined time at a predetermined temperature in a predetermined atmosphere. Subsequently, a photoresist pattern having an opening for exposing part of the surface of the third semiconductor layer 52 in the semiconductor layered structure is formed by photolithography. Then, the opening is etched. The etching may be performed by wet etching and/or dry etching (for example, reactive ion etching). Then, by performing the etching until the surface of the first semiconductor layer 20 is exposed from the surface of the third semiconductor layer 52 corresponding to the opening, an etched semiconductor layered structure is formed.

Subsequently, the etched semiconductor layered structure is washed to thereby remove the photoresist pattern. After the photoresist pattern is removed, a photoresist pattern with an opening having a predetermined shape is formed by photolithography at a predetermined region of the surface of the first semiconductor layer 20 that is exposed outward. Then, on this opening, the first electrode 60 is formed by vacuum vapor deposition (for example, by resistance heating, by electron beam vapor deposition, or by sputtering). After the photoresist pattern used to form the first electrode 60 is removed and then washing is conducted, the etched semiconductor layered structure with the first electrode 60 formed therein is annealed at a predetermined temperature for a predetermined time in an inactive atmosphere or an active atmosphere, thereby forming a semiconductor layered structure having the first electrode 60.

Then, by photolithography, a photoresist pattern with an opening having a predetermined shape is formed at a predetermined region of the surface of the third semiconductor layer 52 in the semiconductor layered structure having the first electrode 60. Then, the second electrode 65 is formed by vacuum vapor deposition in the same manner as the forming of the first electrode 60. After the photoresist pattern used for forming the second electrode 65 is removed and then washing is conducted, the semiconductor layered structure with the second electrode 65 formed therein is annealed at a predetermined temperature for a predetermined time in an active atmosphere or an inactive atmosphere, thereby forming a wafer having a light-emitting element structure.

Then, by a wafer cutting device such as a dicer, the resulting wafer is cut into pieces having a predetermined rectangular size, thereby manufacturing the light-emitting element 1 according to the embodiment.

Note that each semiconductor layer included in the light-emitting element 1 may also be configured such that the conductivity type of a compound semiconductor layer, which constitutes each semiconductor layer of this embodiment, can be reversed. For example, the first conductivity type may be of the p-type, whereas the second conductivity type may be of the n-type.

In this embodiment, a description was given of the light-emitting element 1 which emits light of a wavelength corresponding to deep ultraviolet light. However, it is also possible to form a light-emitting element which emits light of a wavelength corresponding to light different from the deep ultraviolet light such as ultraviolet light, blue light, or green light by controling the composition of the compound semiconductor constituting the light-emitting layer 30 and/or the quantum well structure. Then, the light-emitting layer 30 may also be formed of an active layer undoped or doped with a predetermined dopant, a single quantum well structure, or a multiple quantum well structure.

Furthermore, the planar shape of the light-emitting element 1 is not limited to the aforementioned embodiment. For example, if the planar size of the light-emitting element 1 is designed so that the longitudinal size is less than the lateral size, the light-emitting element 1 takes a generally rectangular shape when viewed in a plan view.

Furthermore, in this embodiment, a description was given of the light-emitting diode structure by way of example. However, it is also possible to form a semiconductor laser which has the semiconductor layered structure according to this embodiment.

### (Effects of embodiments)

The light-emitting element 1 according to the embodiments can improve the external quantum efficiency of the light-emitting element 1 by allowing substantially no dopant to exist in the interface between the well layer 304 closest to the carrier block layer 40 and the spacer layer 35 or by controlling the dopant at a predetermined impurity concentration.

### EMBODIMENTS

In Embodiment 1, a light-emitting element was manufactured which had the following structure as well as the structure shown in Fig. 1 which is the same as that of the light-emitting element 1 manufactured in the manufacturing processes according to the embodiments of the present invention.

First, a C-plane AlN substrate having a square side of 7 mm and a thickness of 500 µm was prepared as the substrate 10. Then, the AlN substrate was set in the MOCVD equipment. Next, an Al_{0.75}Ga_{0.25}N layer having a thickness of 1.0 µm and doped with Si (where Si concentration was 1 × 10¹⁹ cm⁻³) was formed by MOCVD on top of the AlN substrate as the first semiconductor layer 20. Then, a quantum well layer which had barrier layers and well layers was formed as the light-emitting layer 30 on top of the first semiconductor layer 20.

An Al_{0.65}Ga_{0.35}N layer having a thickness of 7 nm and doped with Si was formed as the barrier layer, while an undoped Al_{0.5}Ga_{0.5}N layer having a thickness of 4 nm (where the Si concentration of the barrier layer was 1 × 10¹⁸ cm⁻³) was formed as the well layer. Furthermore, the quantum well layer was configured to include three well layers and three barrier layers. In other words, three pairs of a barrier layer and a well layer were formed from the first semiconductor layer 20 side. Note that each barrier layer had the same composition and thickness. Likewise, each well layer had the same composition and thickness. Furthermore, the spacer layer 35 was formed on top of the light-emitting layer 30. An undoped Al_{0.65}Ga_{0.35}N layer having a thickness of 20 nm was formed as the spacer layer 35.

Next, an AlN layer having a thickness of 15 nm and doped with Mg (where the Mg concentration was 5 × 10¹⁹ cm⁻³, and the band gap of AlN was 6.00 eV) was formed on top of the spacer layer 35 as the carrier block layer 40. Then, an Al_{0.80}Ga_{0.20}N layer having a thickness of 35 nm and doped with Mg (where the Mg concentration was 5 × 10¹⁹ cm⁻³) was formed on top of the carrier block layer 40 as the second semiconductor layer 50. The second semiconductor layer 50 serves as a p-type clad layer. Furthermore, a GaN layer having a thickness of 70 nm and doped with Mg (where the Mg concentration was 2 × 10¹⁹ cm⁻³, and the band gap of GaN was 3.40 eV) was formed on top of the second semiconductor layer 50 as the third semiconductor layer 52. The third semiconductor layer 52 serves as a p-type contact layer. In this manner, the semiconductor layered structure (hereafter simply referred to as "the semiconductor layered structure") was formed on top of the AlN substrate.

Subsequently, a heat treatment was performed on the light-emitting element structure under the following conditions, i.e., at 900°C for 20 minutes in a nitrogen atmosphere. Then, a photoresist pattern having an opening of a predetermined shape was formed by photolithography on the surface of the third semiconductor layer 52 (i.e., a p-type contact layer). Next, until the surface of the first semiconductor layer 20 was exposed, the opening was treated by reactive ion etching. Subsequently, the first electrode 60 was formed by vacuum vapor deposition on the surface of the first semiconductor layer 20. Specifically, the first electrode 60 was formed by forming sequentially, from the first semiconductor layer 20 side, in the following order: a Ti layer (having a thickness of 20 nm); an Al layer (having a thickness of 200 nm); and an Au layer (having a thickness of 5 nm). Then, a heat treatment was performed on the semiconductor layered structure, in which the first electrode 60 was formed, under the following conditions, i.e., at 810°C for 1 minute in a nitrogen atmosphere.

Next, the second electrode 65 was formed on the surface of the third semiconductor layer 52 by vacuum vapor deposition. Specifically, the second electrode 65 was formed by sequentially forming in the following order from the third semiconductor layer 52 side: an Ni layer (having a thickness of 20 nm), and an Au layer (having a thickness of 50 nm). Then, a heat treatment was performed on the semiconductor layered structure, in which the second electrode 65 was formed, under the following conditions, i.e., at 550°C for 3 minutes in an oxygen atmosphere. In this manner, a wafer having the light emission structure was manufactured.

Then, using a dicer, the wafer was cut into chips of a square side of 700 µm, thereby manufacturing the nitride semiconductor light-emitting element according to Embodiment 1.

Then, the properties of the manufactured nitride semiconductor light-emitting element according to Embodiment 1 were evaluated.

Here, employed for the evaluation of the composition of each semiconductor layer were the X-ray diffraction method (XRD), the Transmission Electron Microscope - Energy Dispersive X-ray spectrometry (TEM-EDX), and the three-dimensional Atom Probe method (3DAP). Furthermore, the evaluation of the dopant concentration of each semiconductor layer was conducted using the Secondary Ion-microprobe Mass Spectrometer (SIMS). Furthermore, employed for the evaluation of the light emission wavelength of the light-emitting layer 30 was the photoluminescence (PL) method. Using these analytical techniques, it was confirmed that the composition and the dopant concentration of each semiconductor layer were as described above.

Furthermore, the Mg concentration in the interface between the last well layer (i.e., the well layer 304 closest to the carrier block layer) and the spacer layer 35 was evaluated. As a result, it was shown that in the light-emitting element 1 according to Embodiment 1, the Mg concentration in the interface is 4.36 × 10¹⁶ cm⁻³, and thus Mg as a dopant did not substantially reach the interface.

Here, the external quantum efficiency of the light-emitting element 1 is determined in proportion to the product of the internal quantum efficiency and the injection efficiency. The internal quantum efficiency depends on the crystalline quality of the light-emitting layer (for example, a well layer constituting the quantum well), and when the crystalline quality of the light-emitting layer is high, the internal quantum efficiency is improved as compared with a low crystalline quality. On the other hand, the injection efficiency depends on the structure of the LED itself, for example, the design values of the LED such as the dopant concentration, composition, and thickness of an n-type layer and a p-type layer. As a result, for the same structure, an increase in the internal quantum efficiency leads to an improvement of the external quantum efficiency of the light-emitting element 1. The reason why the external quantum efficiency is reduced with a decrease in the crystalline quality of the light-emitting layer is thought to be caused by an increase in non-emission transition in a crystalline defect resulting from degradation in crystalline quality. Then, when the light emission wavelength of the light-emitting element 1 is analyzed, an increase in non-emission transition is observed by an increase in the sub-peak emission intensity in a wavelength region that is different from the main peak wavelength. At the same time, as the sub-peak emission intensity increases, degradation in the emission intensity of the main peak wavelength is observed. Thus, with increasing sub-peak emission intensity, the external quantum efficiency is degraded.

In this context, light-emitting elements according to Embodiment 2 and Comparative Examples 1 to 4 were each manufactured. The light-emitting elements according to Embodiment 2 and Comparative Examples 1 to 4 have generally the same structure as that of the light-emitting element 1 according to Embodiment 1 except that the Mg concentration in the interface between the last well layer and the spacer layer 35 was varied.

Fig. 4 is a view illustrating the relation between the sub-peak emission intensity and the Mg concentration of the light-emitting elements according to Embodiments and the light-emitting elements according to Comparative Examples. Specifically, in Fig. 4, the X-axis represents the Mg concentration in the interface between the last well layer and the spacer layer 35, while the Y-axis represents the sub-peak emission intensity (when being driven at 10 mA, in a.u.). Furthermore, Table 1 shows the Mg concentration and the sub-peak intensity in the interface for each of Embodiments and Comparative Examples.

**[Table 1]**

| | Mg CONCENTRATION OF INTERFACE BETWEEN LAST BARRIER LAYER / LAST WELL LAYER (cm⁻³) | SUB-PEAK EMISSION INTENSITY WHEN BEING DRIVEN AT 10 mA (a.u.) |
|---|---|---|
| EMBODIMENT 1 | 4.36E+16 | 0.04 |
| EMBODIMENT 2 | 6.09E+16 | 1.60 |
| COMPARATIVE EXAMPLE 1 | 1.83E+17 | 4.41 |
| COMPARATIVE EXAMPLE 2 | 2.80E+17 | 5.91 |
| COMPARATIVE EXAMPLE 3 | 2.81E+17 | 7.58 |
| COMPARATIVE EXAMPLE 4 | 1.98E+17 | 8.72 |

As can be seen from Fig. 4, it is shown that with increasing Mg concentration in the interface between the last well layer and the spacer layer 35, the sub-peak intensity tended to increase. In other words, it was shown that an increase in the Mg concentration in the interface caused an increase in the non-emission transition of the light-emitting element and degradation in the external quantum efficiency. In other words, it was shown that the external quantum efficiency of the light-emitting element could be improved by substantially preventing Mg or a dopant from the carrier block layer from reaching the interface (or by not allowing dopant substantially to exist in the interface).

Then, it was shown that the sub-peak emission intensity could be significantly reduced by controlling the dopant concentration at the interface between the last well layer and the spacer layer 35 to be 1 × 10¹⁷ cm⁻³ or less, preferably 7 × 10¹⁶ cm⁻³ or less, thus leading to a significant improvement in the external quantum efficiency of the light-emitting element (at least, the sub-peak intensity was "2 (a.u.)" or less).

In the foregoing, although a description was given of the embodiments of the present invention, the embodiments described above are not to limit the inventions according to the scope of the claims. It should also be noted that all the combinations of the features described in the embodiments are not necessarily indispensable to means for solving the problems to be addressed by the invention. Furthermore, the technical elements of the embodiments described above may be applied solely or may also be divided into a plurality of parts to be applied.

### REFERENCE SIGNS LIST

- 1: light-emitting element
- 10: substrate
- 20: first semiconductor layer
- 30: light-emitting layer
- 35: spacer layer
- 40: carrier block layer
- 50: second semiconductor layer
- 52: third semiconductor layer
- 60: first electrode
- 65: second electrode
- 100: band diagram
- 110: concentration profile
- 300: barrier layer
- 302: well layer
- 304: well layer

## Claims

1. A nitride-based semiconductor light-emitting element comprising:
a first semiconductor layer of a first conductivity type;
a second semiconductor layer of a second conductivity type different from the first conductivity type;
a carrier block layer provided in the second semiconductor layer on a side closer to the first semiconductor layer and containing an impurity of the second conductivity type;
a light-emitting layer provided between the first semiconductor layer and the carrier block layer; and
a spacer layer which is provided between the carrier block layer and the light-emitting layer and makes a concentration of the impurity of the second conductivity type in a vicinity of an interface with the light-emitting layer be at a predetermined concentration or less.

2. The nitride-based semiconductor light-emitting element according to claim 1, wherein the spacer layer controls the concentration of the impurity of the second conductivity type in the vicinity of the interface at 1 × 10¹⁷ cm⁻³ or less.

3. The nitride-based semiconductor light-emitting element according to claim 1 or 2, wherein
the light-emitting layer is a quantum well layer with a barrier layer and a well layer layered alternately,
the spacer layer is in contact with the well layer, and
a concentration of the impurity of the second conductivity type of an interface between the spacer layer and the well layer is 1 × 10¹⁷ cm⁻³ or less.

4. The nitride-based semiconductor light-emitting element according to any one of claims 1 to 3, wherein
the first semiconductor layer is provided on top of a semiconductor substrate, and
the first semiconductor layer, the second semiconductor layer, the light-emitting layer, and the carrier block layer are configured to contain an AlGaN-based semiconductor.

5. The nitride-based semiconductor light-emitting element according to claim 4, wherein the semiconductor substrate is an AlN substrate, and the first semiconductor layer is provided on a C-plane of the AlN substrate.

6. The nitride-based semiconductor light-emitting element according to any one of claims 1 to 5, wherein the impurity of the second conductivity type is Mg, Zn, Ca, C, or Be.

## Amended claims

### Amended claims under Art. 19.1 PCT

**1.** (amended) A nitride-based semiconductor light-emitting element comprising:
a first semiconductor layer of a first conductivity type;
a second semiconductor layer of a second conductivity type different from the first conductivity type;
a carrier block layer provided in the second semiconductor layer on a side closer to the first semiconductor layer and containing an impurity of the second conductivity type;
a light-emitting layer provided between the first semiconductor layer and the carrier block layer; and
a spacer layer which is provided between the carrier block layer and the light-emitting layer and makes a concentration of the impurity of the second conductivity type in a vicinity of an interface with the light-emitting layer be at a predetermined concentration or less,
wherein the spacer layer controls the concentration of the impurity of the second conductivity type in the vicinity of the interface at 1 × 10¹⁷ cm⁻³ or less.

**2.** (amended) The nitride-based semiconductor light-emitting element according to claim 1, wherein
the light-emitting layer is a quantum well layer with a barrier layer and a well layer layered alternately,
the spacer layer is in contact with the well layer, and
a concentration of the impurity of the second conductivity type of an interface between the spacer layer and the well layer is 1 × 10¹⁷ cm⁻³ or less.

**3.** (amended) The nitride-based semiconductor light-emitting element according to claim 1 or 2, wherein
the first semiconductor layer is provided on top of a semiconductor substrate, and
the first semiconductor layer, the second semiconductor layer, the light-emitting layer, and the carrier block layer are configured to contain an AlGaN-based semiconductor.

**4.** (amended) The nitride-based semiconductor light-emitting element according to claim 3, wherein the semiconductor substrate is an AlN substrate, and the first semiconductor layer is provided on a C-plane of the AlN substrate.

**5.** (canceled)

**6.** (canceled)
